# EUROPÄISCHE PATENTSCHRIFT

(11) **EP 2 361 443 B1**
(45) Veröffentlichungstag und Bekanntmachung des Hinweises auf die Patenterteilung: **16.01.2013**
(21) Anmeldenummer: 09756426.4
(22) Anmeldetag: 06.11.2009
(51) Int. Cl.: H02N 2/18, H01L 41/113

(54) **ELEKTROMECHANISCHER ENERGIEWANDLER ZUR ERZEUGUNG VON ELEKTRISCHER ENERGIE AUS MECHANISCHEN BEWEGUNGEN**
ELECTROMECHANICAL ENERGY CONVERTER FOR GENERATING ELECTRIC ENERGY FROM MECHANICAL MOVEMENTS
CONVERTISSEUR D'ÉNERGIE ÉLECTROMÉCANIQUE DESTINÉ À PRODUIRE DE L'ÉNERGIE ÉLECTRIQUE À PARTIR DE MOUVEMENTS MÉCANIQUES

(30) Priorität: 06.11.2008 DE 102008056127
(43) Veröffentlichungstag der Anmeldung: 31.08.2011
(73) Patentinhaber: Albert-Ludwigs-Universität Freiburg, 79104 Freiburg (DE)
(72) Erfinder: EICHHORN, Christoph, 79106 Freiburg (DE); WOIAS, Peter, 79102 Freiburg (DE); GOLDSCHMIDTBÖING, Frank, 79183 Waldkirch (DE)
(74) Vertreter: Huwer, Andreas
(86) Internationale Anmeldenummer: PCT/EP2009/007959
(87) Internationale Veröffentlichungsnummer: WO 2010/052009

(56) Entgegenhaltungen:
- WO-A-2008/150536
- US-A1- 2006 175 937
- YUANTAI HU ET AL: "A piezoelectric power harvester with adjustable frequency through axial preloads" SMART MATERIALS AND STRUCTURES, IOP PUBLISHING LTD., BRISTOL, GB, Bd. 16, Nr. 5, 1. Oktober 2007 (2007-10-01), Seiten 1961-1966, XP020120611 ISSN: 0964-1726 in der Anmeldung erwähnt
- CHO Y-H ET AL: "Snapping microswitches with adjustable acceleration threshold" SENSORS AND ACTUATORS A, ELSEVIER SEQUOIA S.A., LAUSANNE, CH, Bd. 54, Nr. 1-3, 1. Juni 1996 (1996-06-01), Seiten 579-583, XP004077928 ISSN: 0924-4247

## Beschreibung

Die Erfindung betritt einen elektromechanischen Energiewandler zur Erzeugung von elektrischer Energie aus mechanischen Bewegungen, mit mindestens einem Biegebalken, der an einer Befestigungsstelle an einer in Bewegung versetzbaren Halterung eingespannt ist und mit einem von der Befestigungsstelle entfernten freien Endbereich aus einer Neutrallage quer zur Längserstreckung des Biegebalkens relativ zur Befestigungsstelle entlang einer Bahnkurve auslenkbar ist, wobei eine auslenkbare Stelle des Biegebalkens zum Aufbringen einer im Wesentlichen in Längserstreckungsrichtung des Biegebalken orientierten mechanischen Vorspannung auf den Biegebalken über mindestens ein sich entlang des Biegebalkens erstreckendes, auslenkbares Brückenteil mit der Halterung verbunden ist, mit einer Stelleinrichtung zum Einstellen der von dem Brückenteil auf den Biegebalkens übertragenen Vorspannung, und mit mindestens einem elektromechanischen Wandlerelement, das zum Umwandeln von mechanischer Bewegungsenergie in elektrische Energie mit dem Biegebalken in Antriebsverbindung steht. Dabei können die Bewegungen insbesondere Schwingungen und/oder Stöße umfassen.

Ein derartiger Energiewandler ist aus Hu, Yuanttai et al. "A piezoelectric power harvester with adjustable frequency through axial preloads", Smart Materials and Structures 16 (2007), Seite 1961-1966 bekannt. Er weist einen einseitig an einer Halterung eingespannten Biegebalken mit rechteckigem Querschnitt auf, der mit seinem von der Halterung entfernten freien Ende normal zu seiner Erstreckungsebene elastisch auslenkbar ist. Der Biegebalken hat eine in seiner Erstreckungsebene angeordnete metallische Zentralschicht, die an ihrer Oberseite und ihrer Unterseite jeweils mit einer piezoelektrischen Schicht beschichtet ist, die parallel zur Zentralschicht verläuft. Die Halterung wird normal zur Erstreckungsebene Biegebalken mit einer sinusförmigen mechanischen Vibrationsschwingung angeregt. Durch die Schwingung wird das von der Halterung entfernte freie Ende des Biegebalkens normal zur Erstreckungsebene des Biegebalkens relativ zur Halterung elastisch auslenkt. Beim Auslenken des Biegebalkens tritt an den piezoelektrischen Schichten eine elektrische Spannung auf, die einen elektrischen Verbraucher, wie z.B. einen elektronischen Mikrosensor, speist.

Ein weiteres Beispiel ist aus US2006/175937 bekannt.

Zum Einstellen der Resonanzfrequenz des Biegebalkens hat die Zentralschicht mittig eine Durchtrittslochung, die sich in Längsrichtung des Biegebalkens erstreckt und von einer Schraube durchsetzt wird, die mit ihrem Gewinde mit der Halterung verschraubt ist und mit ihrem Schraubenkopf am freien Ende des Biegebalkens anliegt. Mit Hilfe der Schraube kann der Biegebalken in Axialrichtung gestaucht werden, um eine mechanische Vorspannung auf den Biegebalken aufzubringen. Mit Hilfe der Vorspannung soll es möglich sein, die Resonanzfrequenz des Biegebalkens zu verändern und an die Frequenz der Vbrationsschwingung anzupassen. Dadurch soll bei der Konvertierung der Vibrationsschwingungen in elektrische Energie ein höherer Wirkungsgrad erreicht werden. Bei dieser Art der Vorspannungserzeugung wird jedoch insbesondere bei breitbandigen mechanischen Anregungsschwingungen und bei großen Anregungsamplituden nur ein relativ geringer Teil der mechanischen Vbrationsenergie in elektrische Energie umgewandelt.

Es besteht deshalb die Aufgabe, einen elektromechanischen Energiewandler der eingangs genannten Art zu schaffen, der eine effiziente Umwandlung von mechanischer Schwingungsenergie in elektrische Energie ermöglicht.

Diese Aufgabe wird dadurch gelöst, dass das Brückenteil derart außerhalb des Biegebalkens angeordnet ist, dass der Biegebalken und das Brückenteil sich zumindest bei aus der Neutrallage ausgelenktem Biegebalken und vorhandener Vorspannung entlang von Linien erstrecken, die einen unterschiedlichen Verlauf aufweisen.

Die Linie, entlang der sich das Brückenteil erstreckt, kann also von der Biegelinie des Biegebalkens abweichen. Die Linien sind voneinander unabhängig und müssen nicht notwendigervveise denselben Verlauf haben. Dadurch ist es möglich, an der Stelle des Biegebalkens, an der das Brückenteil am Biegebalken angreift, eine Vorspannkraft in den Biegebalken einzuleiten, die schräg zu einer Tangente an die Biegelinie an der betreffenden Stelle des Biegebalkens verläuft, wobei der Winkel zwischen der Tangente und der Richtung der Vorspannkraft von der Auslenkung des Biegebalkens abhängig ist In vorteilhafter weise wird dadurch eine breitbandige Anregung des Biegebalkens ermöglicht. Dabei kann die an den Biegebalken angelegte Vorspannung sogar größer sein als die Eulersche Knicklast des Biegebalkens, so dass die energetisch günstigste Position des Biegebalkens dann nicht mehr in der Neutrallage des Biegebalkens sondern in beidseits der Neutrallage befindlichen ausgelenkten Balkenpositionen befindet. Bei jedem Umknicken des Biegebalkens kann dann elektrische Energie gewonnen werden. Selbstverständlich ist es aber auch möglich, die Vorspannkraft kleiner als die Eulersche Knicklast zu wählen, insbesondere um eine hohe Güte des aus dem Biegebalken und dem Brückenteil gebildeten schwingungsfähigen Systems zu erreichen. Wenn die Vorspannkraft wesentlich kleiner ist als die Eulersche Knicklast, schwingt der Biegebalken im wesentlichen sinusförmig. Bei Erhöhung der Vorspannkraft werden in zunehmendem Maße Oberwellen in dem Biegebalken angeregt, wodurch beispielsweise stoßförmige oder sprungartige Anregungsschwingungen besser zur Erzeugung von elektrischer Energie genutzt werden können.

Bei einer vorteilhaften Ausgestaltung der Erfindung ist das Brückenteil an der Halterung eingespannt und zugsweise elastisch biegbar ausgestaltet. Der elektromechanische Energiewandler ermöglicht dadurch einen einfachen Aufbau.

Bei einer anderen vorteilhaften Ausgestaltung der Erfindung ist das Brückenteil an einer von der auslenkbaren Stelle des Biegebalkens beabstandeten ersten Gelenkstelle über ein erstes Schwenkgelenk mit der Halterung und/oder an einer von der Befestigungsstelle beabstandeten Stelle angeordneten zweiten Gelenkstelle über ein zweites Schwenkgelenk mit dem Biegebalken verschwenkbar verbunden, wobei eine Schwenkachse des ersten Schwenkgelenks und/oder eine Schwenkachse des zweiten Schwenkgelenks vorzugsweise normal zu der Ebene verlaufen, in der sich die Bahnkurve erstreckt, entlang welcher der freie Endbereich des Biegebalkens auslenkbar ist. Das Mitschwingen des Brückenteils vergrößert dann die Dämpfung des Biegebalkens nur geringfügig, so dass die mechanische Vbrationsenergie noch verlustarmer in elektrische Energie konvertiert werden kann. Das erste Schwenkgelenk und/oder das zweite Schwenkgelenk ist (sind) vorzugsweise als Festkörpergelenke ausgestaltet

Bei einer bevorzugten Ausführungsfbrm der Erfindung erstrecken sich in der Neutrallage des βrückenteils der Biegebalken und das mindestens eine Brückenteil in derselben Ebene und sind normal zur Längserstreckung des Biegebalkens seitlich zueinander versetzt. Der Biegbalken und das mindestens eine Brückenteil können dann einstückig miteinander verbunden und als kostengünstig herstellbares flächiges Bauteil ausgestaltet sein.

Bei einer zweckmäßigen Ausgestaltung der Erfindung ist das mindestens eine Brückenteil quer zur Längserstreckung des Biegebalkens von diesem durch einen sich entlang des Biegebalkens erstreckenden, vorzugsweise schlitzförmigen Freiraum beabstandet, wobei das Brückenteil an seinem von der Halterung entfernten Ende über ein Querverbindungsstück mit der auslenkbaren Stelle des Biegebalkens verbunden ist. Die mechanische Schwingungsenergie kann dann noch effizienter in elektrische Energie umgewandelt werden. Das Brückenteil, das Querstück der Biegebalken und ggf. die Halterung können einstückig miteinander verbunden sein.

Vorteilhaft ist, wenn der Biegebalken und das mindestens eine Brückenteil in Neutrallage in parallel zueinander verlaufenden, in Richtung der Bahnkurve, entlang welcher der freie Endbereich des Biegebalkens auslenkbar ist, zueinander versetzten Ebenen angeordnet und durch einen Bewegungsfreiraum in Richtung der Bahnkurve voneinander beabstandet sind. Der Biegebalken und das Brückenteil sind also übereinander angeordnet, was eine kompakte Bauform ermöglicht.

Das mindestens eine Wandlerelement ist bevorzugt ein Piezoelement, das in den Biegebalkens integriert und vorzugsweise in einer oberflächennahen Schicht des Biegebalkens angeordnet ist. Dadurch kann die Baugröße des elektromechanischen Energiewandlers noch weiter reduziert werden.

Bei einer vorteilhaften Ausgestaltung der Erfindung weist die Stelleinrichtung als Stellglied mindestens ein Piezoelement auf, das zwischen dem Brückenteil und der Halterung und/oder zwischen dem Brückenteil und dem Biegebalken angeordnet ist und/oder in das Brückenteil integriert ist. Mit Hilfe des Piezoelements kann die Vorspannkraft für den Biegebalken auf einfache Weise erzeugt und ggf. an das Frequenzspektrum der mechanischen Vibrationsschwingungen angepasst werden.

Das Stellglied kann auch in mindestens einer oberflächennahen Schicht des Brückenteils angeordnet sein.

Vorteilhaft ist, wenn an die Halterung mindestens ein sich quer zur Längserstreckung des Biegebalkens erstreckender Arm angeformt ist, der einen Armabschnitt aufweist, der in Längserstreckung des Biegebalkens relativ zu der Halterung auslenkbar ist, wobei dieser Armabschnitt über das Brückenteil mit der auslenkbaren Stelle des Biegebalkens verbunden ist, und wobei zwischen dem Armabschnitt und einer an der Halterung vorgesehenen Widerlagerstelle das Stellglied angeordnet ist. Für das Stellglied kann dann zwischen der Halterung und dem Arm ein relativ großer Bauraum vorgesehen sein. Außerdem kann der Arm als Hebel genutzt werden, um den Stellweg des Stellelements über- oder untersetzt auf die Brückenteile zu übertragen.

Vorteilhaft ist, wenn der elektromechanische Energiewandler mindestens zwei Brückenteile aufweist, und wenn der Biegebalken symmetrisch zwischen diesen Brückenteilen angeordnet ist. Der Biegebalkens ist dann gegen Torsion um seine Längsachse stabilisiert. Es ist aber auch möglich, dass der elektromechanische Energiewandler mindestens zwei Biegebalken aufweist, und dass das Brückenteil symmetrisch zwischen diesen Biegebalken angeordnet ist. Auch durch diese Maßnahme können Torsionsschwingungen des Biegebalken vermieden werden.

Bei einer bevorzugten Ausgestaltung der Erfindung weist der elektromechanische Energiewandler eine Steuereinrichtung mit einem Eingang für ein von der Frequenz einer mechanischen Schwingung der Halterung abhängiges Steuersignal auf, wobei die Steuereinrichtung derart mit der Stelleinrichtung in Steuerverbindung steht, dass die Vorspannung in Abhängigkeit von der Frequenz der mechanischen Schwingung einstellbar ist. In vorteilhafter Weise passt sich dadurch die Resonanzfrequenz des Biegebalkens jeweils so an die Frequenz oder das Frequenzband der mechanischen Schwingungen an, dass ein möglichst großer Teil der mechanischen Schwingungsenergie in elektrische Energie umgeformt wird.

Zweckmäßigerweise sind die Steuereinrichtung und/oder ein mit dem Wandlerelement elektrisch verbundener Energiespeicher und/oder ein am Wandlereiement angeschlossener elektrischer Verbraucher an dem Biegebalken mit Abstand zur Befestigungsstelle vorzugsweise am freien Endbereich des Biegebalkens angeordnet. Die Steuereinrichtung, der Energiespeichers und/oder der elektrische Verbraucher können dann als seismische Masse genutzt werden, welche die Resonanzfrequenz des Biegebalkens herabsetzt. Des Weiteren wird durch die zusätzliche seismische Masse sie Konversionseffizienz erhöht. Durch den Biegebalken sind die genannten elektrischen Komponenten außerdem gegen an der Halterung angreifende mechanische Stöße gefedert. Die elektrischen Verbindungen zwischen der Steuereinrichtung, dem Energiespeicher und/oder dem elektrischen Verbraucher können über in den Biegebalken integrierte Leiterbahnen realisiert sein.

Vorteilhaft ist, wenn der elektromechanische Energiewandler eine Messeinrichtung zum Detektieren einer Änderung der von dem Wandlerelement abgegebenen elektrischen Leistung und Mittel zur Erfassung einer Frequenzänderung der mechanischen Schwingung des Biegebalkens aunveist, und wenn die Messeinrichtung und die Mittel zur Erfassung der Frequenzänderung derart über einen Regelkreis mit der Stelleinrichtung zusammenwirken,
- dass bei einer gleichzeitigen Abnahme von Frequenz und Leistung das Stellglied der Stelleinrichtung im Sinne einer Reduzierung der Resonanzfrequenz des Biegebalkens und/oder
- dass bei einer Zunahme der Frequenz und einer gleichzeitigen Abnahme der Leistung das Stellglied der Stelleinrichtung im Sinne einer Erhöhung der Resonanzfrequenz des Biegebalkens
verstellt wird. Dadurch wird der Arbeitspunkt des Energiewandlers beim Auftreten einer Änderung der Anregungsfrequenz an der Halterung jeweils in Richtung des Betriebspunktes verstellt, in dem der Energiewandler seine maximale elektrische Leistung abgibt. Die Verstellung des Arbeitspunktes erfolgt vorzugsweise solange, bis sich die abgegebene elektrische Leistung nicht mehr verändert und der Arbeitspunkt somit in dem Betriebspunkt liegt, in dem der Energiewandler seine maximale elektrische Leistung abgibt.

Nachfolgend sind Ausfährungsbeispiele der Erfindung anhand der Zeichnung näher erläutert. Es zeigt
- Fig. 1: eine Aufsicht auf ein erstes Ausführungsbeispiel eines elektromechanischen Energiewandlers, der einen an einer Halterung einseitig eingespannten Biegebalken aufweist, der senkrecht zur Zeichenebene auslenkbar ist,
- Fig. 2: einen Längsschnitt durch den in Fig. 1 gezeigten Energiewandler, wobei die durchgezogenen Linien den Energiewandler in Neutrallage und die punktierten Linien den. Energiewandler in ausgelenkter Position darstellen, und wobei die Auslenkung vergrößert dargestellt ist,
- Fig. 3: eine Aufsicht auf ein zweites Ausführungsbeispiel des Energiewandlers,
- Fig. 4: einen Längsschnitt durch ein drittes Ausführungsbeispiel des Energiewandlers, wobei die durchgezogenen Linien den Energiewandler in Neutrallage und die punktierten Linien den Energiewandler in ausgelenkter Position darstellen, und wobei die Auslenkung vergrößert dargestellt ist,
- Fig. 5: einen Längsschnitt durch ein viertes Ausführungsbeispiel des Energiewandlers,
- Fig. 6: eine Aufsicht auf ein fünftes Ausführungsbeispiel des Energiewandlers,
- Fig. 7: eine Aufsicht auf ein sechstes Ausführungsbeispiel des Energiewandlers,
- Fig. 8: eine Aufsicht auf ein siebtes Ausführungsbeispiel des Energiewandlers,
- Fig. 9: eine Aufsicht auf ein achtes Ausführungsbeispiel des Energiewandlers und
- Fig. 10: eine Aufsicht auf ein neuntes Ausführungsbeispiel des Energiewandlers.

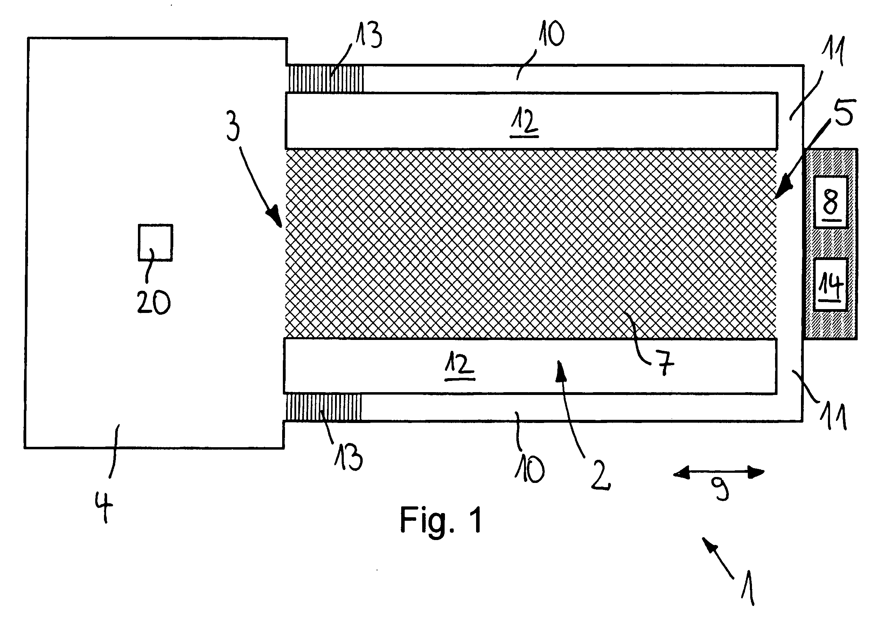

Ein in Fig. 1 im Ganzen mit 1 bezeichneter elektromechanischer Energiewandler zur Erzeugung von elektrischer Energie aus mechanischen Schwingungen hat einen mikromechanischen Biegebalken 2, der an einer Befestigungsstelle 3 fest mit einer Vibrationsschwingungen aufweisenden Halterung 4 verbunden ist. Der Biegebalken 2 hat einen etwa rechteckigen Querschnitt und weist für Verfurmungen in der Zeichenebene ein größeres Biegewiderstandsmoment auf als für Verformungen rechtwinklig zur Zeichenebene.

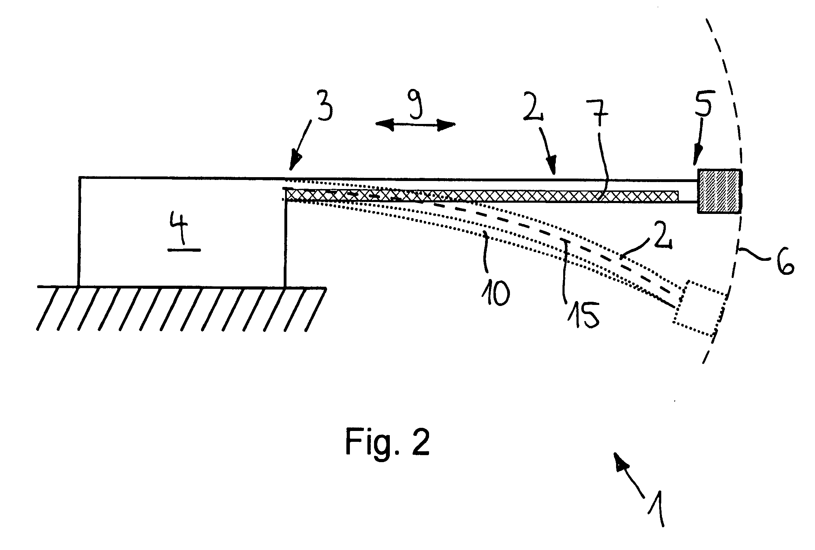

Ein von der Befestigungsstelle 3 entfernter freier Endbereich 5 des Biegebalkens 2 ist aus einer Neutrallage, in welcher der Biegebalken 2 in einer der Zeichenebene in Fig. 1 entsprechenden Ebene angeordnet ist, etwa rechtwinklig zu dieser Ebene entgegen der Rückstellkraft des Werkstoffs des Biegebalkens 2 elastisch auslenkbar. Wie in Fig. 2 erkennbar ist, bewegt sich dabei der Endbereich 5 des Biegebalkens 2 entlang einer gekrümmten Bahnkurve 6.

Zum Umwandeln von mechanischer Schwingungsenergie in elektrische Energie ist ein elektromechanisches Wandlerelement 7 in den Biegebalken integriert. Als Wandlerelement 7 ist ein erstes Piezoelement vorgesehen, das in einer oberflächennahen Schicht des Biegebalken 2 angeordnet ist und bei einer Biegeverformung des Biegebalkens 2 axial gedehnt bzw. gestaucht wird. Aufgrund von Ladungsverschiebungen in dem Piezoelement tritt dabei an in der Zeichnung nicht näher dargestellten Elektroden des Piezoelements eine elektrische Spannung auf, die einen elektrischen Verbraucher 8 speist.

Der freie Endbereich 5 des Biegebalkens 2 ist über zwei außerhalb des Biegebalkens 2 angeordnete Brückenteile 10 mit der Halterung 4 verbunden. Die Brückenteile 10 verlaufen bei in Neutrallage befindlichem Biegebalken 2 beidseits des Biegebalkens 2 etwa parallel zum diesem und sind jeweils durch einen schlitzförmigen Freiraum quer zur Längserstreckungsrichtung 9 des Biegebalkens 2 von diesem beabstandet. In Neutrallage des Biegebalkens 2 sind die Brückenteile 10 und der Biegebalkens 2 in derselben Ebene angeordnet.

Die Brückenteile 10 sind mit ihrem einen Ende fest mit der Halterung 4 verbunden bzw. an dieser eingespannt und mit ihrem davon entfernten anderen Ende etwa rechtwinklig zu der Ebene, in der sich der Biegebalken 2 in Neutrallage erstreckt, elastisch auslenkbar. In Fig. 1 ist erkennbar, dass das von der Halterung 4 entfernte Ende jedes Brückenteils 10 jeweils über ein Querverbindungsstück 11 mit dem freien Endbereich 5 des Biegebalkens 2 verbunden ist. Das Querverbindungsstück 11 verläuft bei in Neutrallage befindlichem Biegebalken 2 in der Ebene, in welcher der Biegebalken 2 angeordnet ist, quer zur Längserstreckungsrichtung 9 des Biegebalkens 2.

Die Halterung 4, der Biegebalken 2, die Brückenteile 10 und die Querverbindungsstücke 11 sind einstückig miteinander verbunden. Sie können beispielsweise bestehen vorzugsweise aus Kunststoff. In Fig. 1 ist erkennbar, dass die Brückenteile 10 seitlich jeweils durch einen etwa parallel zu dem Biegebalken 2 verlaufenden schlitzförmigen Freiraum 12 von dem Biegebalken 2 beabstandet sind.

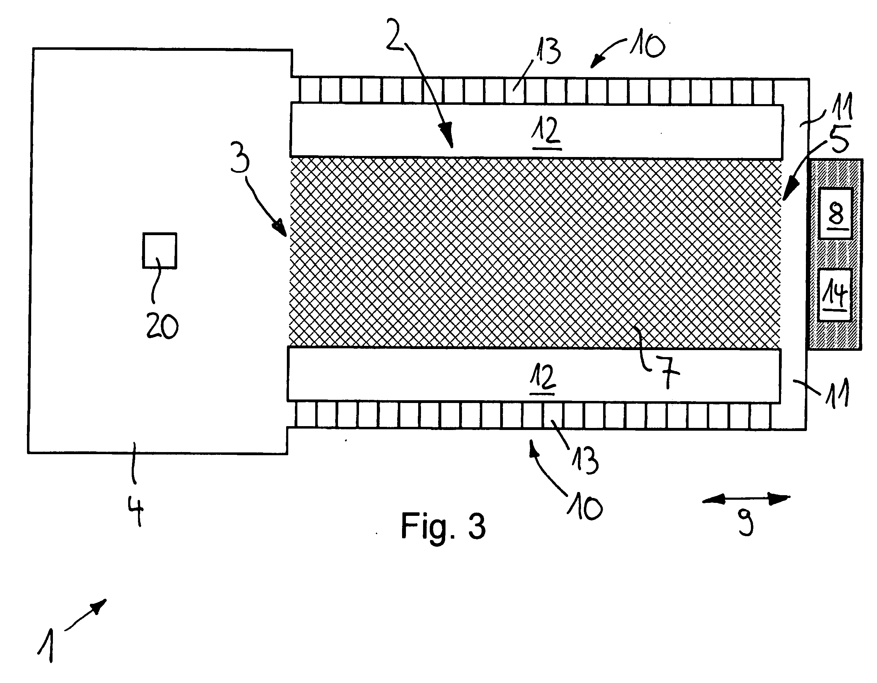

Zum Aufbringen einer im Wesentlichen in Längserstreckungsrichtung 11 der Brückenteile 10 orientierten mechanischen Vorspannung auf den Biegebalken 2 ist eine Stelleinrichtung vorgesehen, die für jedes Brückenteil 10 jeweils als Stellglied 1 3 ein zweites Piezoelement aufweist Das Stellglied 13 ist jeweils in das Brückenteil 10 integriert. Bei dem Ausführungsbeispiel gemäß Fig. 1 und 2 erstreckt sich das Stellglied 1 3 jeweils nur über einen Abschnitt des Brückenteils 10. Bei dem in Fig. 3 gezeigten Ausftihrungsbeispiel verläuft das Stellglied 1 3 durchgängig über nahezu die gesamte Länge des Brückenteil 10. Mit Hilfe des Stellglieds 1 3 kann die axiale Länge des Brückenteils 10 verkürzt und/oder vergrößert werden, indem an das Stellglied 1 3 mit Hilfe einer Steuereinrichtung 14 eine elektrische Spannung angelegt wird. Wird die Länge des Brückenteils 10 verkürzt wird, nimmt die Resonanzfrequenz des aus dem Biegebalken 2 und dem Brückenteil 10 gebildeten schwingungsfähigen Systems ab. Wird die Länge des Brückenteils 10 vergrößert, nimmt die Resonanzfrequenz des schwingungsfähigen Systems zu.

In Fig. 2 ist erkennbar, dass sich der Biegebalken 2 entlang einer gekrümmten Biegelinie 15 erstreckt, wenn er aus der Neutrallage ausgelenkt ist, und dass die Linie, entlang der sich jeweils das Brückenteil 10 erstreckt, bei vorhandener Vorspannung von der Biegelinie des Biegebalkens 2 abweicht. Die Linie, entlang der sich das Brückenteil 10 erstreckt, weist eine andere Geometrie auf als die Biegelinie 15 und ist kürzer als diese.

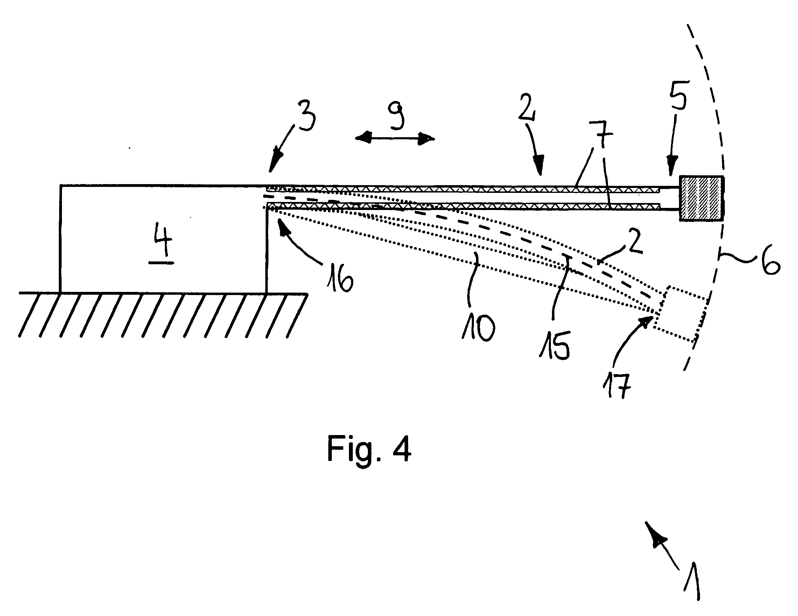

Bei dem in Fig. 4 gezeigten Ausführungsbeispiel ist das Brückenteil 10 an einer vom freien Endbereich 5 des Biegebalkens 2 beabstandeten ersten Gelenkstelle 16 über ein erstes Schwenkgelenk mit der Halterung 4 und einer am freien Endbereich 5 des Biegebalkens 2 vorgesehenen zweiten Gelenkstelle 17 über ein zweites Schwenkgelenk verschwenkbar mit dem Biegebalken 2 bzw. dem Querverbindungsstück 11 verbunden. Dadurch hat das Brückenteil 10 auch bei aus der Neutrallage ausgelenktem Biegebalken 2 einen etwa geraden Verlauf. Die Schwenkgelenke sind vorzugsweise als Festkörpergelenke ausgestaltet, deren Schwenkachsen normal zu der Ebene verlaufen, in der sich die Bahnkurve 6 erstreckt.

Bei dem in Fig. 4 gezeigten Ausführungsbeispiel hat das Wandlerelement 7 des Biegebalkens 2 jeweils beidseits einer Mittelschicht eine piezoelektrische Schicht, die zur Erzeugung von elektrischer Energie genutzt wird. Bei Auslenkung des Biegebalkens 2. aus der Neutrallage wird jeweils eine der piezoelektrischen Schichten gestaucht und die andere gedehnt.

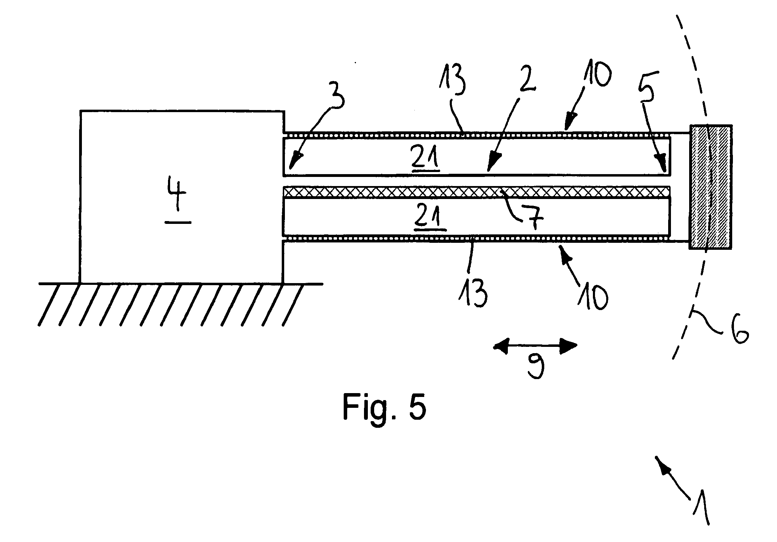

Bei dem in Fig. 5 gezeigten Ausführungsbeispiel sind der Biegebalken 2 und die beiden Brückenteile 10 in Neutrallage in parallel zueinander verlaufenden Ebenen angeordnet. Zwischen dem Brückenteil 10 und dem Biegebalken 2 ist jeweils ein etwa parallel zu dem Biegebalken 2 verlaufenden schlitzförmigen Bewegungsfreiraum 21 vorgesehen. Die Brückenteile 10 sind spiegelsymmetrisch zur Längsmit telachse des Biegebalkens 2 angeordnet.

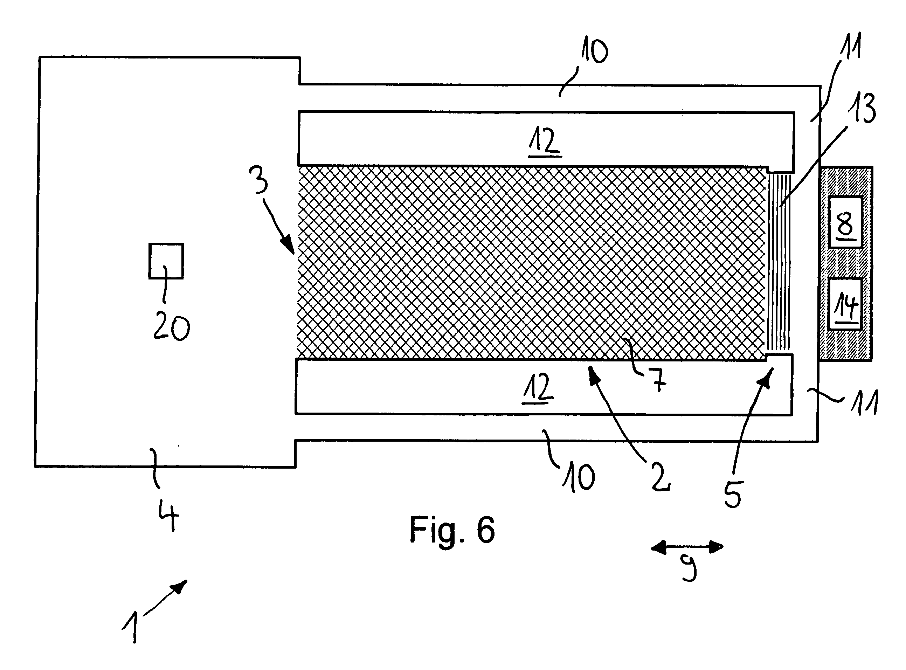

Bei dem in Fig. 6 abgebildeten Ausführungsbeispiel ist das als Piezoelement ausgestaltete Stellglied 1 3 zwischen dem stirnseitigen freien Ende des Biegebalkens 2 und den Querverbindungsstücken 11 angeordnet. Dadurch ist es möglich, die maxiale Länge des Biegebalkens 2 im Verhältnis zur axialen Länge der Brückenteile 10 zu verändern und somit eine axiale Vorspannung auf den Biegebalken 2 auszuüben. Zusätzlich wirkt das Stellglied 1 3 als seismische Masse.

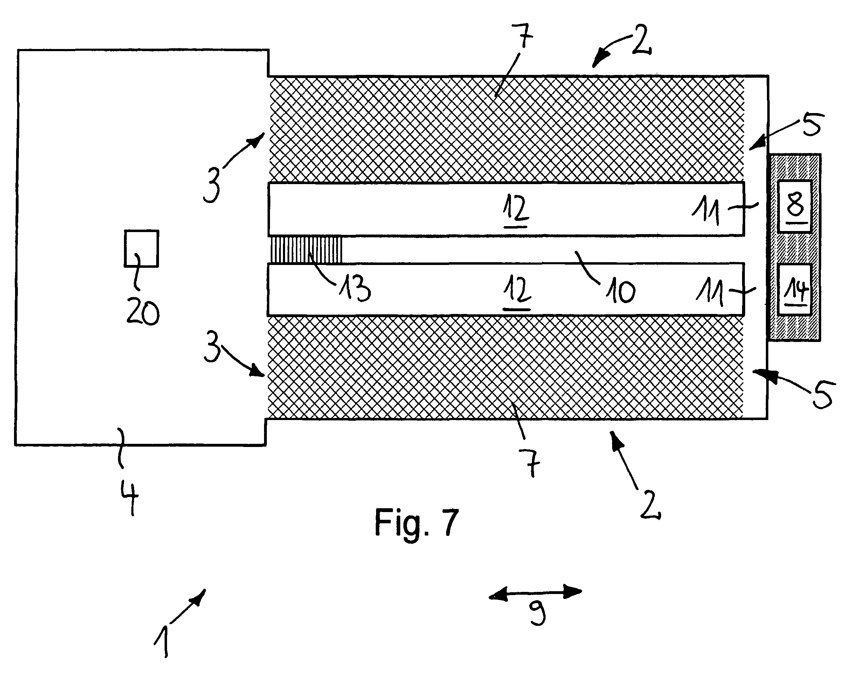

Bei dem in Fig. 7 gezeigten Ausihrungsbeispiel hat der Energiewandler 1 zwei parallel zueinander verlaufende, einseitig an der Halterung 2 eingespannte Biegebalken 2, zwischen denen ein ebenfalls einseitig an der Halterung 2 eingespanntes Brückenteil 10 angeordnet ist. Bei in Neutrallage befindlichem Biegebalken 2 erstrecken sich die Brückenteile 10 und der Biegebalken 2 in derselben Ebene. Der Biegebalken 2 ist seitlich beidseits jeweils durch einen schlitzförmigen, etwa parallel zum Biegebalken 2 verlaufenden Freiraum 12 von dem betreffenden Brückenteil 10 beabstandet. Deutlich ist erkennbar, dass die Biegebalken 2 spiegelsymmetrisch zur Längsmittelachse des Brückenteil 10 angeordnet sind.

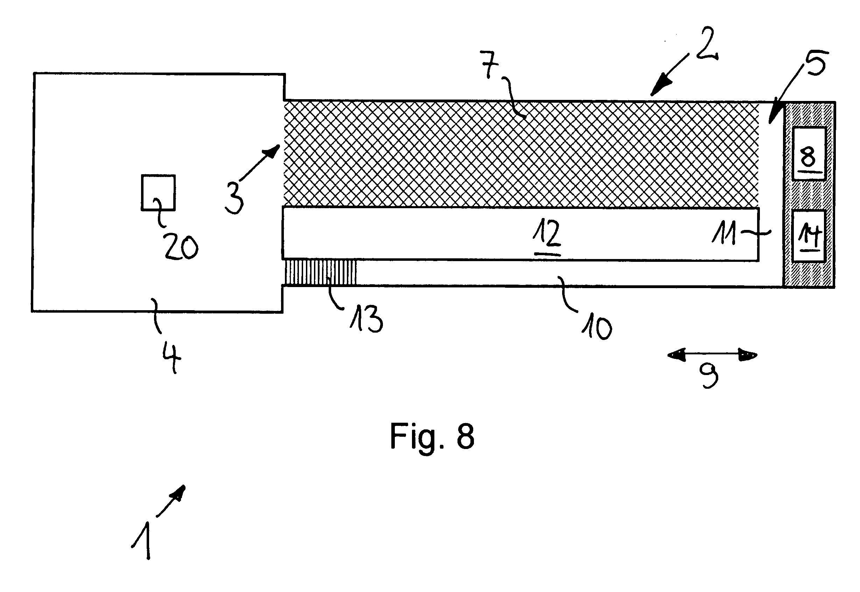

In Fig. 8 ist erkennbar, dass der Biegebalken 2 und das Brückenteil 10 auch asymmetrisch zueinander angeordnet sein können.

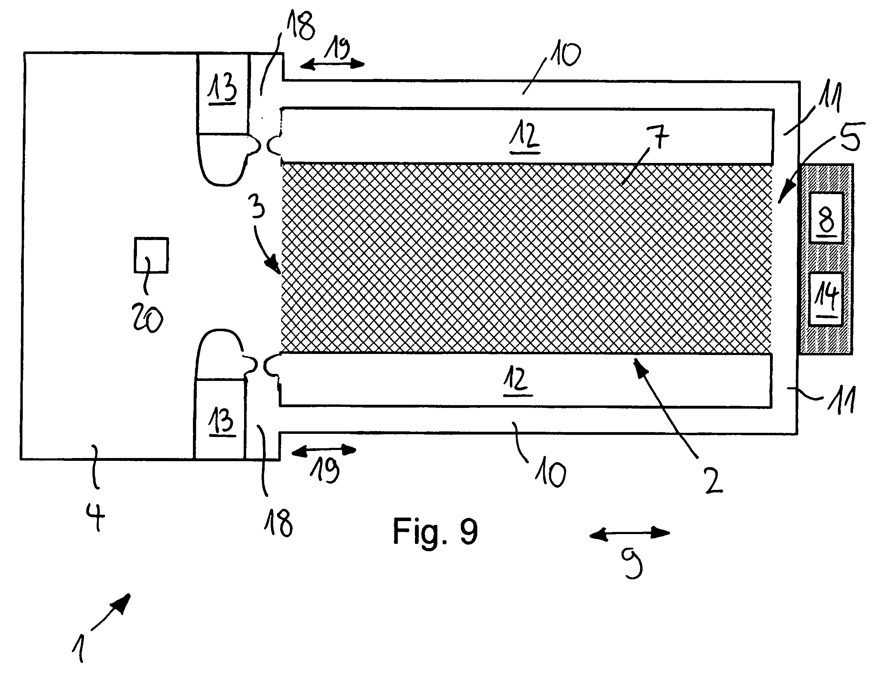

Bei dem in Fig. 9 gezeigten Energiewandler 1 sind an die Halterung 4 zwei sich etwa rechtwinklig zur Längserstreckung 9 des Biegebalkens 2 in zueinander entgegen gesetzte Richtungen weisende Arme 1 8 angeformt, die in der Ebene angeordnet sind, in der sich der Biegebalken 2 in Neutrallage erstreckt. Jeder Arm 1 8 hat jeweils einen Armabschnitt, der in Längserstreckung 9 des Biegebalkens 2 relativ zu der Halterung 4 auslenkbar ist. Zwischen diesem Armabschnitt und der Halterung 4 ist an der den Brückenteilen 1 0 abgewandten Seite der Arme 1 8 jeweils ein Freiraum 12 gebildet, in dem als Stellglied 13 ein Piezoelement angeordnet ist. Das Stellglied 1 3 ist jeweils mit seinem einen Ende gegen den auslenkbaren Armabschnitt und mit seinem anderen Ende gegen eine Widerlagerstelle der Halterung 4 abgestützt. Die auslenkbaren Armabschnitte sind jeweils mit dem von dem freien Endbereich 5 entfernten Ende des dem betreffenden Arm 1 8 zugeordneten Brückenteils 10 verbunden. Mit Hilfe der Stellglieder 13 können die Arme 18 in Richtung der Doppelpfeile 19 verstellt werden.

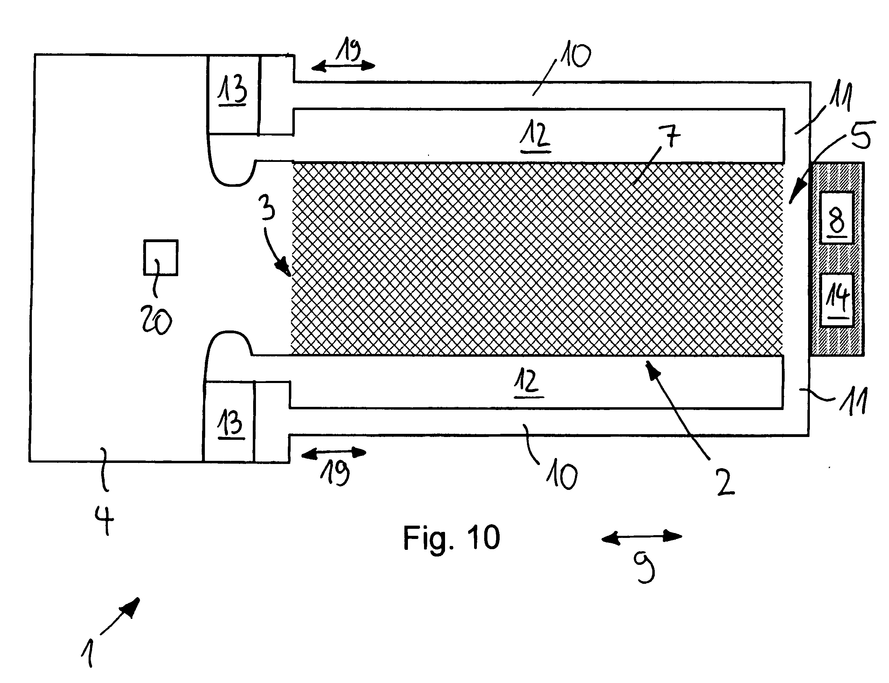

Wie in Fig. 10 erkennbar ist, können die Stellglieder 1 3 auch über eine freistehende Struktur mit den Brückenteilen 10 verbunden sein.

Erwähnt werden soll noch, dass die Steuereinrichtung 14 einen Messsignaleingang aufweist, an dem ein von der Frequenz der mechanischen Anregungsschwingung abhängiges Steuersignals anliegt. Das Steuersignal wird mit Hilfe eines an der Halterung 4 angeordneten Sensors 20 erfasst. Das mindestens eine Stellglied 1 3 steht derart mit der Steuereinrichtung 14 in Steuerverbindung, dass die auf den Biegebalken 2 ausgeübte mechanische Vorspannung in Abhängigkeit von der Frequenz der mechanischen Schwingung jeweils so eingestellt wird, dass bei der Konvertierung der mechanischen Schwingungen in die elektrische Energie ein möglichst großer Wirkungsgrad erreicht wird.

Die Steuereinrichtung 14 und ein mit dem Wandlerelement 7 verbundener elektrischer Verbraucher 14 sind an dem Biegebalken 2 mit Abstand zur gungsstelle 3 angeordnet und dienen als seismische Masse.

Erwähnt werden soll noch, dass bei den in der Zeichnung dargestellten Ausihrungsbeispielen anstelle der Steuereinrichtung 14 auch ein Regelkreis vorgesehen sein kann, der derart ausgestaltet ist, dass das Stellglied 1 3 jeweils so angesteuert, wird, dass der Energiewandler 1 in einem Arbeitspunkt betrieben wird, an dem er seine maximale Leistung abgibt.

## Patentansprüche

1. Elektromechanischer Energiewandler (1) zur Erzeugung von elektrischer Energie aus mechanischen Bewegungen, mit mindestens einem Biegebalken (2), der an einer Befestigungsstelle (3) an einer in Bewegung versetzbaren Halterung (4) eingespannt ist und mit einem von der Befestigungsstelle (5) entfernten freien Endbereich (5) aus einer Neutrallage quer zur Längserstreckung (9) des Biegebalkens (2) relativ zur Befestigungsstelle (3) entlang einer Bahnkurve (6) auslenkbar ist, wobei eine auslenkbare Stelle des Biegebalkens (2) zum Aufbringen einer im Wesentlichen in Längserstreckungsrichtung (9) des Biegebalkens (2) orientierten mechanischen Vorspannung auf den Biegebalkens (2) über mindestens ein sich entlang des Biegebalkens (2) erstreckendes, auslenkbares Brückenteil (10) mit der Halterung (4) verbunden ist, mit einer Stelleinrichtung zum Einstellen der von dem Brückenteil (10) auf den Biegebalken (2) übertragenen Vorspannung, und mit mindestens einem elektromechanischen Wandlerelement das zum Umwandeln von mechanischer Bewegungsenergie in elektrische Energie mit dem Biegebalken (2) in Antriebsverbindung steht, dadurch gekenntzeichnet dass das Brückenteil (10) derart außerhalb des Biegebalkens (2) angeordnet ist, dass der Biegebalken (2) und das Brückenteil (10) sich zumindest bei aus der Neutrallage ausgelenktem Biegebalken (2) und vorhandener Vorspannung entlang von Linien erstrecken, die einen unterschiedlichen Verlauf aufweisen.

2. Elektromechanischer Energiewandler (1) nach Anspruch 1, **dadurch gekennzeichnet, dass** das Brückenteil (10) an der Halterung (4) eingespannt und vorzugsweise elastisch biegbar ist.

3. Elektromechanischer Energiewandler (1) nach Anspruch 1 oder 2, **dadurch gekennzeichnet, dass** das Brückenteil (10) an einer von der auslenkbaren Stelle des Biegebalkens (2) beabstandeten ersten Gelenkstelle (16) über ein erstes Schwenkgelenk mit der Halterung (4) und/oder an einer von der Befestigungsstelle (3) beabstandeten Stelle angeordneten zweiten Gelenkstelle (17) über ein zweites Schwenkgelenk mit dem Biegebalken (2) verschwenkbar verbunden ist, und dass eine Schwenkachse des ersten Schwenkgelenks und/oder eine Schwenkachse des zweiten Schwenkgelenks vorzugsweise normal zu der Ebene verlaufen, in der sich die Bahnkurve (6) erstreckt, entlang welcher der freie Endbereich (5) des Biegebalkens (2) auslenkbar ist.

4. Elektromechanischer Energiewandler (1) nach einem der Ansprüche 1 bis 3, **dadurch gekennzeichnet, dass** sich in der Neutrallage des Biegebalkens (2) der Biegebalken (2) und das mindestens eine Brückenteil (10) in derselben Ebene erstrecken und normal zur Längserstreckung (9) des Biegebalkens (2) seitlich zueinander versetzt sind.

5. Elektromechanischer Energiewandler (1) nach einem der Ansprüche 1 bis 4, **dadurch gekennzeichnet, dass** das mindestens eine Brückenteil (10) quer zur Längserstreckung (9) des Biegebalkens (2) durch einen sich entlang des Biegebalkens (2) erstreckenden, vorzugsweise schlitzförmigen Freiraum (12) beabstandet ist, und dass das Brückenteil (10) an seinem von der Halterung (4) entfernten Ende über ein Querverbindungsstück (11) mit der auslenkbaren Stelle des Biegebalkens (2) verbunden ist.

6. Elektromechanischer Energiewandler (1) nach einem der Ansprüche 1 bis 5, **dadurch gekennzeichnet, dass** der Biegebalken (2) und das mindestens eine Brückenteil (10) in Neutrallage in parallel zueinander verlaufenden, in Richtung der Bahnkurve (6), entlang welcher der freie Endbereich des Biegebalkens (2) auslenkbar ist, zueinander versetzten Ebenen angeordnet und durch einen Bewegungsfreiraum (21) in Richtung der Bahnkurve (6) voneinander beabstandet sind.

7. Elektromechanischer Energiewandler (1) nach einem der Ansprüche 1 bis 6, **dadurch gekennzeichnet, dass** das mindestens eine Wandlerelement (7) ein Piezoelement ist, das in den Biegebalken (2) integriert und vorzugsweise in einer oberflächennahen Schicht des Biegebalkens (7) angeordnet ist.

8. Elektromechanischer Energiewandler (1) nach einem der Ansprüche 1 bis 7, **dadurch gekennzeichnet, dass** die Stelleinrichtung als Stellglied (13) mindestens ein Piezoelement aufweist, das zwischen dem Brückenteil (10) und der Halterung (4) und/oder zwischen dem Brückenteil (10) und dem Biegebalken (2) angeordnet ist und/oder in das Brückenteil (10) integriert ist.

9. Elektromechanischer Energiewdndler (1) nach einem der Ansprüche 1 bis 8, **dadurch gekennzeichnet, dass** an die Halterung (4) mindestens ein sich quer zur Längserstreckung (9) des Biegebalkens (2) erstreckender Arm (18) angeformt ist, der einen Armabschnitt aufweist, der in Längserstreckung (9) des Biegebalkens (2) relativ zu der Halterung (4) auslenkbar ist, dass dieser Armabschnitt über das Brückenteil (10) mit der auslenkbaren Stelle des Biegebalkens (2) verbunden ist, und dass zwischen dem Armabschnitt und einer an der Halterung (4) vorgesehenen Widerlagerstelle das Stellglied (13) angeordnet ist.

10. Elektromechanischer Energiewandler (1) nach einem der Ansprüche 1 bis 9, **dadurch gekennzeichnet, dass** er mindestens zwei Brückenteile (10) aufweist, und dass der Biegebalkens (2) symmetrisch zwischen diesen Brückenteilen (10) angeordnet ist.

11. Elektromechanischer Energiewandler (1) nach einem der Ansprüche 1 bis 10, **dadurch gekennzeichnet, dass** er mindestens zwei Biegebalken (2) aufweist, und dass das Brückenteil (10) symmetrisch zwischen diesen Biegebalken (2) angeordnet ist.

12. Elektromechanischer Energiewandler (1) nach einem der Ansprüche 1 bis 11, **dadurch gekennzeichnet, dass** er eine Steuereinrichtung (14) mit einem Eingang für ein von der Frequenz einer mechanischen Schwingung der Halterung (4) abhängiges Steuersignal aufweist, und dass die Steuereinrichtung (14) derart mit der Stelleinrichtung in Steuerverbindung steht, dass die Vorspannung in Abhängigkeit von der Frequenz der mechanischen Schwingung einstellbar ist.

13. Elektromechanischer Energiewandler (1) nach einem der Ansprüche 1 bis 12, **dadurch gekennzeichnet, dass** die Steuereinrichtung (14) und/oder ein mit dem Wandlerelement (7) elektrisch verbundener Energiespeicher und/oder ein am Wandlerelement (7) angeschlossener elektrischer Verbraucher (8) an dem Biegebalken (2) mit Abstand zur Befestigungsstelle (3) vorzugsweise am freien Endbereich (5) des Biegebalkens (2) angeordnet sind.

14. Elektromechanischer Energiewandler (1) nach einem der Ansprüche 1 bis 13, **dadurch gekennzeichnet, dass** er eine Messeinrichtung zum Detektieren einer Änderung der von dem Wandlerelement (7) abgegebenen elektrischen Leistung und Mittel zur Erfassung einer Frequenzänderung der mechanischen Schwingung des Biegebalkens (2) aufweist, und dass die esseinrichtung und die Mittel zur Erfassung der Frequenzänderung derart über einen Regelkreis mit der Stelleinrichtung zusammenwirken,
- dass bei einer gleichzeitigen Abnahme von Frequenz und Leistung das Stellglied (13) der Stelleinrichtung im Sinne einer Reduzierung der Resonanzfrequenz des Biegebalkens (2) und/oder
- dass bei einer Zunahme der Frequenz und einer gleichzeitigen Abnahme der Leistung das Stellglied (13) der Stelleinrichtung im Sinne einer Erhöhung der Resonanzfrequenz des Biegebalkens (2)
verstellt wird.

## Claims

1. Electromechanical energy converter (1) for generating electrical energy from mechanical movements, having at least one bending bar (2) which is clamped in at an attachment point (3) on a mount (4) which can be set in motion, and can be deflected, with a free end regimen (5) which is remote from the attachment point (5), out of a neutral position in the transverse direction with respect to the longitudinal extent (9) of the bending bar (2) relative to the attachment point (3) along a trajectory (6), wherein a deflectable point on the bending bar (2) for applying a mechanical prestress, oriented essentially in the direction (9) of the longitudinal extent of the bending bar (2), to the bending bar (2) via at least one deflectable bridge part (10), extending along the bending bar (2), is connected to the mount (4), having an adjustment device for adjusting the prestress which is transmitted from the bridge part (10) to the bending bar (2), and having at least one electromechanical converter element (7) which has a drive connection to the bending bar (2) for converting mechanical kinetic energy into electrical energy, **characterized in that** the bridge part (10) is arranged outside the bending bar (2) in such a way that the bending bar (2) and the bridge part (10) extend, aL least when the bending bar (2) is deflected out of the neutral position and the prestress is present, along lines which have a different profile.

2. Electromechanical energy converter (1) according to Claim 1, **characterized in that** the bridge part (10) is clamped in on the mount (4) and is preferably elastically bendable.

3. Electromechanical energy converter (1) according to Claim 1 or 2, **characterized in that** the bridge part (10) is pivotably connected to the mount (4) via a first pivot joint at a first articulation point (16) spaced apart from the deflectable point on the bending bar (2) and/or to the bending bar (2) via a second pivot joint at a second articulation point (17) arranged at a point spaced apart from the attachment point (3), and **in that** a pivoting axis of the first pivot joint and/or a pivoting axis of the second pivot joint preferably run in a perpendicular direction with respect to the plane in which the trajectory (6), along which the free end region (5) of the bending bar (2) can be deflected, extends.

4. Electromechanical energy converter (1) according to one of Claims 1 to 3, **characterized in that** the bending bar (2) and the at least one bridge part (10) extend in the same plane in the neutral position of the bending bar (2) and are offset laterally with respect to one another in the perpendicular direction with respect to the longitudinal extent (9) of the bending bar (2).

5. Electromechanical energy converter (1) according to one of Claims 1 to 4, **characterized in that** the at least one bridge part (10) is spaced apart in the transverse direction with respect to the longitudinal extent (9) of the bending bar (2) by a preferably slit-shaped free space (12) which extends along the bending bar (2), and **in that** the bridge part (10) is connected, at its end remote from the mount (4), to the deflectable point on the bending bar (2) via a transverse connecting piece (11).

6. Electromechanical energy converter (1) according to one of Claims 1 to 5, **characterized in that** the bending bar (2) and the at least one bridge part (10) are arranged in planes which run parallel to one another in the neutral position and are offset with respect to one another in the direction of the trajectory (6) along which the free end region of the bending bar (2) can be deflected, and said bending bar (2) and the at least one bridge part (10) are spaced apart from one another in the direction of the trajectory (6) by a movement free space (21).

7. Electromechanical energy converter (1) according to one of Claims 1 to 6, **characterized in that** the at least one converter element (7) is a piezo-element which is integrated into the bending bar (2) and is preferably arranged in a layer of the bending bar (7) which is near to the surface.

8. Electromechanical energy converter (1) according to one of Claims 1 to 7, **characterized in that** the adjustment device has, as an actuator element (13), at least one piezo-element which is arranged between the bridge part (10) and the mount (4) and/or between the bridge part (10) and the bending bar (2) and/or is integrated into the bridge part (10).

9. Electromechanical energy converter (1) according to one of Claims 1 to 8, **characterized in that** at least one arm (18) which extends transversely with respect to the longitudinal extent (9) of the bending bar (2) is arranged on the mount (4), which arm (18) has an arm section which can be deflected relative to the mount (4), in the longitudinal extent (9) of the bending bar (2), **in that** this arm section is connected via the bridge part (10) to the deflectable point on the bending bar (2), and **in that** the actuator element (13) is arranged between the arm section and a corresponding bearing point provided on the mount (4).

10. Electromechanical energy converter (1) according to one of Claims 1 to 9, **characterized in that** it has at least two bridge parts (10), and **in that** the bending bar (2) is arranged symmetrically between these bridge parts (10).

11. Electromechanical energy converter (1) according to one of Claims 1 to 10, **characterized in that** it has at least two bending bars (2), and **in that** the bridge part (10) is arranged symmetrically between these bending bars (2).

12. Electromechanical energy converter (1) according to one of Claims 1 to 11, **characterized in that** it has a control device (14) with an input for a control signal which is dependent on the frequency of a mechanical oscillation of the mount (4), and **in that** the control device (14) has a control connection to the adjustment device such that the prestress can be adjusted as a function of the frequency of the mechanical oscillation.

13. Electromechanical energy converter (1) according to one of Claims 1 to 12, **characterized in that** the control device (14) and/or an energy accumulator which is electrically connected to the converter element (7) and/or an electrical load (8) which is connected to the converter element (7) are arranged on the bending bar (2) at a distance from the attachment point (3), preferably at the free end region (5) of the bending bar (2).

14. Electromechanical energy converter (1) according to one of Claims 1 to 13, **characterized in that** it has a measuring device for detecting a change in the electrical power which is output by the converter element (7), and means for detecting a change in frequency of the mechanical oscillation of the bending bar (2), and **in that** the measuring device and the means for detecting the change in frequency interact with the adjustment device via a control circuit in such a way
- that given a simultaneous reduction in the frequency and power the actuator element (13) of the adjustment device is adjusted in the direction of reducing the resonant frequency of the bending bar (2), and/or
- that given an ir_crease in the frequency and/or simultaneous reduction in the power the actuator element (13) of the adjustment device is adjusted in the sense of increasing the resonant frequency of the bending bar (2).

## Revendications

1. Convertisseur d'énergie électromécanique (1) pour générer de l'énergie électrique à partir de mouvements mécaniques, comprenant au moins une tige flexible (2) qui est enserrée en un point de fixation (3) sur un support (4) pouvant être mis en mouvement et comprenant une zone d'extrémité libre (5) éloignée du point de fixation (5) qui peut être déviée depuis une position neutre transversalement par rapport à la projection longitudinale (9) de la tige flexible (2) par rapport au point de fixation (3) le long d'une portion de trajectoire (6), un point pouvant être dévié de la tige flexible (2) étant relié avec le support (4) pour appliquer sur la tige flexible (2) une précontrainte mécanique orientée pour l'essentiel dans le sens de la projection longitudinale (9) de la tige flexible (2) par le biais d'au moins une pièce faisant pont (10) pouvant être déviée qui s'étend le long de la tige flexible (2), comprenant un dispositif de réglage pour régler la précontrainte transmise de la pièce faisant pont (10) à la tige flexible (2), et comprenant au moins un élément convertisseur électromécanique (7) qui se trouve en liaison motrice avec la tige flexible (2) en vue de convertir l'énergie de mouvement mécanique en énergie électrique, **caractérisé en ce que** la pièce faisant pont (10) est disposée à l'extérieur de la tige flexible (2) de telle sorte que la tige flexible (2) et la pièce faisant pont (10), au moins lorsque la tige flexible (2) est déviée de la position neutre et en présence de la précontrainte, s'étendent le long de lignes qui présentent des tracés différents.

2. Convertisseur d'énergie électromécanique (1) selon la revendication 1, **caractérisé en ce que** la pièce faisant pont (10) est enserrée sur le support (4) et de préférence flexible avec effet élastique.

3. Convertisseur d'énergie électromécanique (1) selon 1a revendication 1 ou 2, **caractérisé en ce que** la pièce faisant pont (10) est reliée avec le support (4) en un premier point d'articulation (16) espacé du point pouvant être dévié de la tige flexible (2) par le biais d'une première articulation de pivotement et/ou de manière pivotante avec la tige flexible (2) en un deuxième point d'articulation (17) disposé en un point espacé du point de fixation (3) par le biais d'une deuxième articulation de pivotement, et **en ce qu'**un axe de pivotement de la première articulation de pivotement et/ou un axe de pivotement de la deuxième articulation de pivotement s'étendent de préférence dans la direction normale par rapport au plan dans lequel s'étend la portion de trajectoire (6) et le long duquel peut être déviée la zone d'extrémité libre (5) de la tige flexible (2).

4. Convertisseur d'énergie électromécanique (1) selon l'une des revendications 1 à 3, **caractérisé en ce que** dans la position neutre de la tige flexible (2), la tige flexible (2) et l'au moins une pièce faisant pont (10) s'étendent dans le même plan et sont décalées latéralement l'une par rapport à l'autre dans la direction normale par rapport à la projection longitudinale (9) de la tige flexible (2).

5. Convertisseur d'énergie électromécanique (1) selon l'une des revendications 1 à 4, **caractérisé en ce que** l'au moins une pièce faisant pont (10), transversalement par rapport à la projection longitudinale (9) de la tige flexible (2), est espacée par un espace libre (12) de préférence en forme de fente qui s'étend le long de la tige flexible (2), et **en ce que** la pièce faisant pont (10) est reliée avec le point pouvant être dévié de la tige flexible (2) par le biais d'une pièce de liaison transversale (11) au niveau de son extrémité éloignée du support (4).

6. Convertisseur d'énergie électromécanique (1) selon l'une des revendications 1 à 5, **caractérisé en ce que** la tige flexible (2) et l'au moins une pièce faisant pont (10), en position neutre, sont disposées dans des plans décalés l'un de l'autre s'étendant en parallèle l'un à l'autre en direction de la portion de trajectoire (6) le long de laquelle peut être déviée la zone d'extrémité libre de la tige flexible (2) et sont espacées l'une de l'autre par un espace libre de mouvement (21) en direction de la portion de trajectoire (6).

7. Convertisseur d'énergie électromécanique (1) selon l'une des revendications 1 à 6, **caractérisé en ce que** l'au moins un élément convertisseur (7) est un élément piézoélectrique qui est intégré dans la tige flexible (2) et est de préférence disposé dans une couche proche de la surface de la tige flexible (7).

8. Convertisseur d'énergie électromécanique (1) selon l'une des revendications 1 à 7, **caractérisé en ce que** le dispositif de réglage présente comme élément de réglage (13) au moins un élément piézoélectrique qui est disposé entre la pièce faisant pont (10) et le support (4) et/ou entre la pièce faisant pont (10) et la tige flexible (2) et/ou intégré dans la pièce faisant pont (10).

9. Convertisseur d'énergie électromécanique (1) selon l'une des revendications 1 à 8, **caractérisé en ce qu'**au moins un bras (18) qui s'étend transversalement par rapport à la projection longitudinale (9) de la tige flexible (2) est formé sur le support (4), lequel présente une portion de bras qui peut être déviée par rapport au support (4) dans la projection longitudinale (9) de la tige flexible (2), **en ce que** cette portion de bras est reliée par le biais de la pièce faisant pont (10) avec le point pouvant être dévié de la tige flexible (2) et **en ce que** l'élément de réglage (13) est disposé entre la portion de bras et un point d'aboutement prévu sur le support (4).

10. Convertisseur d'énergie électromécanique (1) selon l'une des revendications 1 à 9, **caractérisé en ce qu'**il présente au moins deux pièces faisant pont (10) et **en ce que** la tige flexible (2) est disposée de manière symétrique entre ces pièces faisant pont (10).

11. Convertisseur d'énergie électromécanique (1) selon l'une des revendications 1 à 10, **caractérisé en ce qu'**il présente au moins deux tiges flexibles (2) et **en ce que** la pièce faisant pont (10) est disposée de manière symétrique entre ces tiges flexibles (2).

12. Convertisseur d'énergie électromécanique (1) selon l'une des revendications 1 à 11, **caractérisé en ce qu'**il présente un dispositif de commande (14) muni d'une entrée pour un signal de commande dépendant de la fréquence d'une oscillation mécanique du support (4), et **en ce que** le dispositif de commande (14) se trouve en liaison de commande avec le dispositif de réglage de telle sorte que la précontrainte peut être réglée en fonction de la fréquence de l'oscillation mécanique.

13. Convertisseur d'énergie électromécanique (1) selon l'une des revendications 1 à 12, **caractérisé en ce que** le dispositif de commande (14) et/ou un accumulateur d'énergie en liaison électrique avec l'élément convertisseur (7) et/ou une charge électrique (8) raccordée à l'élément convertisseur (7) sont disposés sur la tige flexible (2) à une certaine distance du point de fixation (3), de préférence à la zone d'extrémité libre (5) de la tige flexible (2).

14. Convertisseur d'énergie électromécanique (1) selon l'une des revendications 1 à 13, **caractérisé en ce qu'**il présente un dispositif de mesure pour détecter une modification de la puissance électrique délivrée par l'élément convertisseur (7) et des moyens pour détecter une modification de la fréquence de l'oscillation mécanique de la tige flexible (2), et **en ce que** le dispositif de mesure et les moyens pour détecter une modification de la fréquence interagissent avec le dispositif de réglage par le biais d'un circuit de régulation de telle sorte
- qu'en cas de diminution simultanée de la fréquence eL de la puissance, l'élément de réglage (13) du dispositif de réglage est ajusté dans le sens d'une réduction de la fréquence de résonance de la tige flexible (2) et/ou
- qu'en cas d' augmentation de la fréquence et d' une diminution simultanée de la puissance, l'élément de réglage (13) du dispositif de réglage est ajusté dans le sens d'une augmentation de la fréquence de résonance de la tige flexible (2).
